# EUROPÄISCHE PATENTSCHRIFT

(11) **EP 3 987 299 B1**
(45) Veröffentlichungstag und Bekanntmachung des Hinweises auf die Patenterteilung: **17.12.2025**
(21) Anmeldenummer: 20753712.7
(22) Anmeldetag: 05.08.2020
(51) Int. Cl.: G01R 31/00

(54) **VERFAHREN UND ANORDNUNG ZUM ERFASSEN EINER DURCH EIN BORDNETZ EINES KRAFTFAHRZEUGS HERVORGERUFENEN ELEKTROMAGNETISCHEN STÖRUNG**
METHOD AND ASSEMBLY FOR DETECTING ELECTROMAGNETIC INTERFERENCE CAUSED BY AN ON-BOARD ELECTRICAL SYSTEM OF A MOTOR VEHICLE
PROCÉDÉ ET ENSEMBLE DE DÉTECTION D'INTERFÉRENCES ÉLECTROMAGNÉTIQUES PROVOQUÉES PAR UN SYSTÈME ÉLECTRIQUE DE BORD D'UN VÉHICULE À MOTEUR

(30) Priorität: 29.08.2019 DE 102019212970
(43) Veröffentlichungstag der Anmeldung: 27.04.2022
(73) Patentinhaber: VOLKSWAGEN AKTIENGESELLSCHAFT, 38440 Wolfsburg (DE)
(72) Erfinder: SASSI, Oussama, 30161 Hannover (DE); ZVIAD KUTCHADZE, Zviad, 0160 Tbilisi (GE); KHVITIA, Badri, 0160 Tbilisi (GE); GHEONJIAN, Anna, 0160 Tbilisi (DE)
(86) Internationale Anmeldenummer: PCT/EP2020/072026
(87) Internationale Veröffentlichungsnummer: WO 2021/037507

(56) Entgegenhaltungen:
- EP-A1- 0 607 481
- JP-A- 2002 318 252
- US-A- 5 739 695
- US-A1- 2017 234 916
- ECHEVERRIA IVAN ET AL: "Common Mode Noise Propagation and Effects in a Four-Wheel Drive Electric Vehicle", IEEE TRANSACTIONS ON ELECTROMAGNETIC COMPATIBILITY, IEEE SERVICE CENTER, NEW YORK, NY, US, vol. 60, no. 1, 28 February 2018 (2018-02-28), pages 132 - 139, XP011661763, ISSN: 0018-9375, [retrieved on 20171005], DOI: 10.1109/TEMC.2017.2701885

## Beschreibung

Die Erfindung betrifft ein Verfahren und eine Anordnung zum Erfassen einer durch ein Bordnetz eines Kraftfahrzeugs hervorgerufenen elektromagnetischen Störung.

Technische Systeme sowie Kraftfahrzeuge sind durch Kundenanforderungen und gesetzliche Vorgaben zur Sicherheit und Qualität sehr komplex geworden. Insbesondere hat eine Anzahl der Elektrik- und Elektronikkomponenten in den Kraftfahrzeugen zugenommen. Hierdurch erhöhen sich die Anforderungen beim Überprüfen der elektromagnetischen Verträglichkeit (EMV) und der elektromagnetischen Verträglichkeit Umwelt (EMVU), wenn diese Systeme und Komponenten in ein Kraftfahrzeug integriert werden.

Jede Komponente wird hierbei einzeln geprüft und für eine Integration in das Kraftfahrzeug freigegeben. Für die Messung der Störaussendung werden die Komponenten nach dem jeweils gültigen CISPR-(Comité international spécial des perturbations radioélectriques)-Standard geprüft, insbesondere nach CISPR 12 und CISPR 25. Nach einem Einbau in ein Kraftfahrzeug werden die Komponenten erneut geprüft, um die Integration der Komponenten in das Kraftfahrzeug sicher zu stellen.

Aus der DE 10 2015 016 308 A1 ist ein Verfahren zur Prognose einer elektromagnetischen Emission in einem Fahrzeug bekannt. Hierzu wird einmalig ein Überkoppelverhalten zwischen mindestens einem Fahrzeugleitungssatz und mindestens einer Fahrzeugantenne im Fahrzeug ermittelt und für jedes Übertragungssystem des Fahrzeugs eine Zeit- und Frequenzinformation ermittelt und die ermittelte Zeit- und Frequenzinformation des jeweiligen Übertragungssystems wird mit dem ermittelten Überkoppelverhalten zusammengeführt, um die daraus resultierende elektromagnetische Emission im Fahrzeug zu prognostizieren.

Aus der CN 109444615 A sind eine Diagnose- und Testvorrichtung und ein Diagnose- und Testverfahren für eine Kabelstrangleitungsinterferenz bekannt. Die Vorrichtung umfasst eine Signalerzeugungseinheit, eine Signalverstärkungseinheit, eine Frequenzerfassungseinheit, eine Steuereinheit und eine Anzeigeeinheit, wobei die Signalerzeugungseinheit zum Bilden eines Interferenzsignals verwendet wird; die Signalverstärkungseinheit wird zum Verstärken des Interferenzsignals und zum Einspeisen des verstärkten Interferenzsignals in ein Kabel eines elektronischen Geräts verwendet. Die Frequenzerfassungseinheit wird zum Erfassen eines Detektionssignals des Kabels des elektronischen Geräts durch eine Erfassungssonde verwendet, wenn das Interferenzsignal eingespeist wird. Die Steuereinheit wird verwendet, um ein Interferenzdetektionsergebnis des Kabels des elektronischen Geräts gemäß dem von der Frequenzerfassungseinheit erfassten Detektionssignal zu erhalten und das Interferenzdetektionsergebnis an die Anzeigeeinheit zu übertragen. Die Anzeigeeinheit wird zum Anzeigen des Interferenzdetektionsergebnisses verwendet, das von der Steuereinheit an einen Benutzer übertragen wird.

Aus der DE 10 2017 111 273 B3 ist eine Vorrichtung zum Überprüfen von in einem Kabelbaum angeordneten Datenleitungen beschrieben, die eine Hochfrequenz-Signalquelle zum Erzeugen von veränderbaren Hochfrequenz-Signalen, eine Antenne, eine Messvorrichtung zum Messen von Signalen, die durch elektromagnetische Felder hervorgerufen werden, die durch die Hochfrequenz-Signale bewirkt werden, sowie eine Auswertungsvorrichtung zum Auswerten der Signale und zum Beurteilen eines Fehlerzustands der Datenleitungen des Kabelbaums durch Vergleich der gemessenen Signale mit Referenzsignalen, die im Fall fehlerfreier Datenleitungen gemessen würden, aufweist. Die Vorrichtung ist so gestaltet, dass beim Überprüfen mehrere Datenleitungen des Kabelbaums mit der Vorrichtung verbunden sind, sodass mehrere Datenleitungen gleichzeitig überprüfbar sind. Es wird ferner ein Verfahren zum gleichzeitigen Überprüfen mehrerer in einem Kabelbaum angeordneten Datenleitungen beschrieben.

Aus der US 2013/0325383 A1 sind ein Verfahren und ein System zur Überwachung und Analyse elektrischer Komponenten bekannt. In einer Variante umfasst das Verfahren das Erhalten von Rohdaten von Hochfrequenzkomponenten, die einer elektrischen Komponente zugeordnet sind, und das Kreuzkorrelieren der Rohdaten von Hochfrequenzkomponenten mit einem synchronisierten Pseudozufallssequenzsignal, das in die elektrische Komponente injiziert wird, um eine korrelierte Impulsantwort zu bestimmen, und Bestimmen eines Zustands der elektrischen Komponente, zumindest teilweise basierend auf der korrelierten Impulsantwort. In einer anderen Variante umfasst das System ein Signalinjektionssystem, das mit einer elektrischen Komponente gekoppelt ist. Das Signalinjektionssystem injiziert ein synchronisiertes Pseudozufallssequenz-Signal in die elektrische Komponente. Ein Datenerfassungsgerät erhält über eine HF-Antenne Rohdaten von Hochfrequenzkomponenten, die mit dem Pseudozufallssequenz-Signal synchronisiert sind. Ein Datenanalysegerät korreliert die Rohdaten der Hochfrequenzkomponente mit dem Pseudozufallssequenz-Signal, um die mit der elektrischen Komponente verbundenen Eigenschaften zu bestimmen.

Aus der US 2017 / 0 234 916 A1 ist ein Fahrzeugkommunikationsdiagnosewerkzeug bekannt. Dieses umfasst eine Antenne, einen Lautsprecher und eine Steuerung. Als Reaktion auf eine Fahrzeugdiagnoseanforderung erzeugt die Steuerung eine Trägerfrequenz, die einer vorbestimmten Frequenz entspricht, die elektromagnetischen Emissionen von einem unausgeglichenen Differentialkanal im Fahrzeug zugeordnet ist. Die Steuerung aktiviert und deaktiviert abwechselnd den Differentialkanal, was zu einer Audiosignatur und einer Basis-Audiosignatur führt. Die Steuerung demoduliert Signale von der Antenne basierend auf der Trägerfrequenz und gibt das demodulierte Signal an den Lautsprecher zur Analyse durch einen Zuhörer aus. Das demodulierte Signal kann von der Steuerung weiterverarbeitet werden, um Emissionen aus dem Kommunikationsnetz zu identifizieren.

Aus der JP 2002 318252 A ist ein Rauschvisualisierungssystem bekannt. Das Rauschvisualisierungssystem hat eine Signalerzeugungseinrichtung zum Anlegen von Hochfrequenzsignalen an ein Testobjekt, eine Antenneneinrichtung zum Erfassen von Rauschen, das von dem Testobjekt erzeugt wird, Visualisierungsmittel für die Visualisierung von Rauschen, das durch das Antennenmittel erfasst wird, während Spannungspegel des Rauschens gemessen werden, das von dem Testobjekt erfasst wird, ein Vergleichsmittel zum Vergleichen der Spannungspegel mit einer voreingestellten Schwelle und ein Ausgabeeinstellmittel, das Ausgabepegel der Hochfrequenzsignale entsprechend dem Ergebnis des Vergleichs durch die Vergleichseinrichtung einstellt.

Aus der EP 0 607 481 A1 sind eine Vorrichtung und ein Verfahren zur Prüfung der Empfindlichkeit gegenüber elektromagnetischen Feldern bekannt. Ivan Echeverria et al., Common Mode Noise Propagation and Effects in a Four-Wheel Drive Electric Vehicle, IEEE Transactions on Electromagnetic Compatibility, Vol. 60, Nr. 1, Februar 2018, IEEE, beschreibt die Charakterisierung von Rauschen und Interferenz in einem Elektrofahrzeug. Aus der US 5 739 695 A ist ein Verfahren zur dynamischen Prüfung von Funksystemen für die Kraftfahrzeugumgebung bekannt.

Der Erfindung liegt die Aufgabe zu Grunde, ein Verfahren und eine Anordnung zum Erfassen einer durch ein Bordnetz eines Kraftfahrzeugs hervorgerufenen elektromagnetischen Störabstrahlung zu schaffen.

Die Aufgabe wird erfindungsgemäß durch ein Verfahren mit den Merkmalen des Patentanspruchs 1 und eine Anordnung mit den Merkmalen des Patentanspruchs 9 gelöst. Vorteilhafte Ausgestaltungen der Erfindung ergeben sich aus den Unteransprüchen.

Insbesondere wird ein Verfahren zum Erfassen einer durch ein Bordnetz eines Kraftfahrzeugs hervorgerufenen elektromagnetischen Störabstrahlung zur Verfügung gestellt, wobei ein Störsignal mittels eines Signalgenerators bereitgestellt wird und mittels eines Verbindungsmittels in das Bordnetz eingespeist wird, wobei ein frequenzaufgelöstes Messsignal mittels einer Testantenne und einer Empfangseinrichtung erfasst wird, und wobei das erfasste frequenzaufgelöste Messsignal mittels der Empfangseinrichtung bereitgestellt und ausgegeben wird.

Ferner wird insbesondere eine Anordnung zum Erfassen einer durch ein Bordnetz eines Kraftfahrzeugs hervorgerufenen elektromagnetischen Störabstrahlung geschaffen, umfassend einen Signalgenerator zum Bereitstellen eines Störsignals, ein Verbindungsmittel zum Einspeisen des Störsignals in das Bordnetz, eine Testantenne und eine Empfangseinrichtung zum Erfassen eines frequenzaufgelösten Messsignals, wobei die Empfangseinrichtung derart ausgebildet ist, das erfasste frequenzaufgelöste Messsignal bereitzustellen und auszugeben.

Das Verfahren und die Anordnung ermöglichen es, eine Störabstrahlung des Bordnetzes des Kraftfahrzeugs direkt zu bestimmen. Hierzu wird ein Störsignal mittels eines Signalgenerators bereitgestellt und mittels eines Verbindungsmittels in das Bordnetz eingespeist. Mittels einer Testantenne und einer Empfangseinrichtung werden ein frequenzaufgelöstes Messsignal erfasst, wobei das erfasste frequenzaufgelöste Messsignal mittels der Empfangseinrichtung bereitgestellt und ausgegeben wird. Das bereitgestellte und eingespeiste Störsignal umfasst zumindest im Zeitverlauf sämtliche Frequenzen, die für einen Test auf elektromagnetische Verträglichkeit notwendig sind.

Der Vorteil des Verfahrens und der Anordnung ist, dass ein Störeinfluss des Bordnetzes direkt erfasst werden kann. Insbesondere vereinfacht eine direkte Erfassung eine Ursachensuche, sodass das Bordnetz oder Teile hiervon zum Sicherstellen einer elektromagnetischen Verträglichkeit einfacher angepasst bzw. optimiert werden können.

Das Störsignal kann sowohl im "common mode" (Gleichtakt) als auch im "differential mode" (Gegentakt) bereitgestellt werden. Im "common mode" wird das Störsignal insbesondere zwischen Masse und einer Versorgungsleitung des Bordnetzes eingespeist. Im "differential mode" wird das Störsignal insbesondere in eine Niedrigpotential- und eine Hochpotentialleitung des Bordnetzes eingespeist. Soll das "differential mode"-Störsignal beispielsweise in einen Controller Area Network-(CAN)-Bus eingespeist werden, so erfolgt dies über die CAN-Low- und CAN-High-Leitungen.

Die Testantenne kann beispielsweise eine Antenne des Kraftfahrzeugs sein, die im regulären Betrieb beispielsweise einem Radio- und/oder Mobilfunkempfang etc. dient. Alternativ kann als Testantenne auch eine Koppelzange direkt am Bordnetz verwendet werden. In einer weiteren Alternative wird eine fahrzeugexterne Testantenne verwendet. Die fahrzeugexterne Antenne kann beispielsweise eine Magnetfußantenne sein, deren Position beispielsweise nach VW TL81000 definiert ist.

Prinzipiell kann als Testantenne auch eine magnetische Feldsonde verwendet werden, sodass ein magnetisches Feld erfasst wird. Hierdurch wird es möglich, eine Exposition durch magnetische Felder zu bestimmen, beispielsweise nach den ICNIRP Guidelines oder IEC TS 62764-1.

Der Signalgenerator stellt insbesondere ein Sinussignal bei unterschiedlichen Frequenzen bereit. Der Signalgenerator ist beispielsweise ein Arbiträrgenerator (engl. Arbitrary Waveform Generator, AWG).

Die Empfangseinrichtung ist beispielsweise ein Spektrumanalysator.

Es kann vorgesehen sein, dass der Signalgenerator und die Empfangseinrichtung in einer gemeinsamen Einrichtung ausgebildet sind, beispielsweise als Electromagnetic Interference-(EMI)-Receiver. Dieser stellt das Störsignal bereit und erfasst zeitgleich das frequenzaufgelöste Messsignal.

Insbesondere ist vorgesehen, dass das Bordnetz, das heißt insbesondere eine Spannungsversorgung, und Komponenten, das heißt insbesondere mit dem Bordnetz verbundene elektrische Verbraucher, beispielsweise Steuergeräte von Systemen des Kraftfahrzeugs, beim Durchführen des Verfahrens betrieben bzw. weiterbetrieben werden. Insbesondere werden das Bordnetz und die Komponenten wie im regulären Betrieb betrieben. Dies ermöglicht das Überprüfen des Bordnetzes unter realen, das heißt insbesondere normalen, Betriebsbedingungen.

Das Verfahren wird insbesondere in einer Testkammer ausgeführt, die als reflexionsarmer Raum (engl. anechoic chamber) ausgestaltet ist. Die Anordnung ist daher zumindest teilweise in einer solchen Testkammer angeordnet oder umfasst diese Testkammer.

In einer Ausführungsform ist vorgesehen, dass mindestens eine Messgröße des erfassten frequenzaufgelösten Messsignals mittels einer Auswerteeinrichtung mit mindestens einem Grenzwert verglichen wird, wobei ein Vergleichsergebnis bereitgestellt und ausgeben wird. Hierdurch kann überprüft werden, ob ein vorgegebener Grenzwert überschritten wird oder nicht. Die mindestens eine Messgröße ist insbesondere ein elektrisches Feld, das von der Testantenne erfasst wird. Alternativ kann auch eine Spannung, ein Strom oder eine Leistung erfasst werden und als Messgröße verwendet werden. Es kann auch vorgesehen sein, dass die mindestens eine Messgröße aus den vorgenannten elektrischen Größen berechnet wird, beispielsweise unter Berücksichtigung von Antennenparametern der Testantenne. Der mindestens eine Grenzwert ergibt sich insbesondere aus gesetzlichen Vorgaben und/oder aus den relevanten Standards zum Überprüfen einer elektromagnetischen Verträglichkeit, beispielsweise nach CISPR, insbesondere nach CISPR 12 und CISPR 25. Der mindestens eine Grenzwert gibt beispielsweise ein maximal erlaubtes elektrisches Feld (am Ort der Testantenne) vor.

In einer Ausführungsform ist vorgesehen, dass zum Bereitstellen des Störsignals eine Frequenz ausgehend von einer Anfangsfrequenz hin zu einer Endfrequenz durchgestimmt wird, wobei hiermit synchronisiert das frequenzaufgelöste Messsignal erfasst wird. Hierdurch kann ein Ablauf des Verfahrens vereinfacht werden. Insbesondere kann ein Frequenzdurchlauf (engl. sweep) erfolgen, bei dem insbesondere schrittweise eine Frequenz eines sinusförmigen Störsignals ausgehend von der Anfangsfrequenz bis zum Erreichen der Endfrequenz erhöht wird. Hierbei wird insbesondere dafür gesorgt, dass das sinusförmige Störsignal bei jedem vorgesehenen Zwischenschritt zumindest eine volle Periode durchläuft. Eine Anfangsfrequenz ist beispielsweise 9 kHz und eine Endfrequenz beispielsweise 1 GHz. Es kann vorgesehen sein, dass eine Schrittweite beim Frequenzdurchlauf dynamisch an den jeweiligen Frequenzbereich angepasst wird, wobei die Schrittweite beispielsweise jeweils in Abhängigkeit einer Größenordnung der jeweiligen Frequenz bzw. des jeweiligen Frequenzbereichs festgelegt wird.

In einer Ausführungsform ist vorgesehen, dass das Vergleichen frequenzaufgelöst erfolgt, wobei ein frequenzaufgelöstes Vergleichsergebnis bereitgestellt und ausgegeben wird. Insbesondere wird für jede bei einer Frequenz erfasste oder aus dem erfassten frequenzabhängigen Messsignal abgeleitete Messgröße überprüft, ob diese den mindestens einen Grenzwert überschreitet. Für jede überprüfte Frequenz wird anschließend frequenzaufgelöst das Vergleichsergebnis bereitgestellt und ausgegeben. Hierdurch wird eine detailliertere Analyse einer Störabstrahlung des Bordnetzes ermöglicht. Insbesondere ermöglicht das frequenzaufgelöste Vergleichsergebnis gezielte Maßnahmen, um das Überschreiten des mindestens einen Grenzwertes zu verhindern, beispielsweise indem Frequenzen oder Frequenzbereiche identifiziert werden, bei denen der mindestens eine Grenzwert überschritten wird. Für diese Frequenzen oder Frequenzbereiche kann dann beispielsweise ein Filter in das Bordnetz eingebracht werden.

In einer Ausführungsform ist vorgesehen, dass beim Vergleichen des erfassten frequenzaufgelösten Messsignals mit dem mindestens einen Grenzwert frequenzabhängige Grenzwerte verwendet werden. Hierdurch können für einzelne Frequenzen und/oder Frequenzbereiche voneinander verschiedene Grenzwerte verwendet und überprüft werden.

In einer Ausführungsform ist vorgesehen, dass eine Amplitude und/oder eine Leistung des Störsignals frequenzabhängig festgelegt ist oder festgelegt wird. Hierdurch können für einzelne Frequenzen und/oder Frequenzbereiche jeweils individuell definierte Testbedingungen geschaffen werden, bei denen beispielsweise auch Eigenschaften der Anordnung bzw. eines verwendeten Signalgenerators und/oder von Verbindungsleitungen etc. berücksichtigt und insbesondere kompensiert werden können. Eine Amplitude bezieht sich hierbei insbesondere auf eine Spannung des Störsignals oder einen Strom des Störsignals. Eine Leistung ist insbesondere eine elektrische Leistung des Störsignals.

In einer weiterbildenden Ausführungsform ist vorgesehen, dass die Amplituden und/oder die Leistungen für die Frequenzen jeweils im Rahmen eines Konfigurierverfahrens bestimmt und festgelegt werden, wobei für eine Frequenz diejenige Amplitude und/oder diejenige Leistung des mittels des Signalgenerators bereitgestellten Störsignals gewählt wird, bei denen in einer definierten Testanordnung jeweils eine maximal erlaubte elektromagnetische Störabstrahlung mittels einer Testantenne erfasst wird. Eine solche definierte Testanordnung entspricht beispielsweise einer Testanordnung, wie diese bei einem Komponententest verwendet wird. Eine Amplitude und/oder eine Leistung des bereitgestellten Störsignals wird dann für jede verwendete Frequenz und/oder für verwendete Frequenzbereiche derart gewählt, dass jeweils die maximal erlaubte elektromagnetische Störabstrahlung erreicht wird. Ein beispielhafter Testaufbau umfasst eine Komponente mit elektrischen Zuleitungen (z.B. Masse und Versorgungspotential) mit einer Länge von 1,5 Metern und keinem Abschlusswiderstand, und eine Testantenne in einem Abstand von 1 Meter von der Komponente bzw. den Zuleitungen (gemäß CISPR25). Wird dies für alle zu testenden Frequenzen durchgeführt, so ergibt sich hieraus eine frequenzabhängige Amplituden- bzw. Leistungskurve des bereitzustellenden Störsignals. Beim Bereitstellen des Störsignals wird eine Amplitude bzw. eine Leistung des Störsignals dann gemäß dieser Amplituden- bzw. Leistungskurve gesteuert oder geregelt.

Es kann vorgesehen sein, dass die Amplituden und/oder Leistungen, insbesondere unmittelbar, vor dem Einspeisen in das Bordnetz mittels eines Regelkreises überprüft und nachgeregelt werden.

In einer Ausführungsform ist vorgesehen, dass das Verbindungsmittel mindestens einen Komponentenstecker umfasst, wobei eine elektrische Verbindung zum Bordnetz zum Einspeisen des Störsignals mittels des mindestens einen Komponentensteckers ausgebildet wird. Hierdurch kann auf eine bereits existierende elektrische Schnittstelle zum Bordnetz des Kraftfahrzeugs zurückgegriffen werden, sodass Aufwand und Kosten eingespart werden können und eine elektrische Verbindung zum Bordnetz des Kraftfahrzeug ohne Weiteres ausgebildet werden kann. Der Komponentenstecker ist derart ausgelegt, dass das Störsignal in die vorgesehenen bzw. zu testenden Leitungen des Bordnetzes eingespeist wird, bei einem "common mode"-Störsignal beispielsweise zwischen Masse und einer Versorgungsleitung und bei einem "differential mode"-Signal beispielsweise in die vorgesehenen bzw. zu testenden Hochpotential- und Niedrigpotentialleitungen (z.B. CAN-High und CAN-Low). Der Komponentenstecker wird beispielweise mit einem komplementär ausgebildeten Bordnetzstecker verbunden. Der Komponentenstecker ist insbesondere ein standardisierter Komponentenstecker.

Weitere Merkmale zur Ausgestaltung der Anordnung ergeben sich aus der Beschreibung von Ausgestaltungen des Verfahrens. Die Vorteile der Anordnung sind hierbei jeweils die gleichen wie bei den Ausgestaltungen des Verfahrens.

Die Anordnung und ein Ablauf des Verfahrens werden insbesondere von einer Steuereinrichtung gesteuert. Die Steuereinrichtung kann hierbei auch als Teil des Signalgenerators und/oder der Empfangseinrichtung und/oder der Auswerteeinrichtung ausgebildet sein. Die Steuereinrichtung kann als eine Kombination von Hardware und Software ausgebildet sein, beispielsweise als Programmcode, der auf einem Mikrocontroller oder Mikroprozessor ausgeführt wird.

Nachfolgend wird die Erfindung anhand bevorzugter Ausführungsbeispiele unter Bezugnahme auf die Figuren näher erläutert. Hierbei zeigen:
- Fig. 1: eine schematische Darstellung einer Ausführungsform der Anordnung zum Erfassen einer durch ein Bordnetz eines Kraftfahrzeugs hervorgerufenen elektromagnetischen Störabstrahlung;
- Fig. 2: eine schematische Darstellung zur Verdeutlichung frequenzabhängiger Amplituden bzw. Leistungen im Störsignal;
- Fig. 3: eine schematische Darstellung zur Verdeutlichung von Amplituden bzw. Leistungen eines Störsignals und von erfassten frequenzabhängigen Messsignalen.

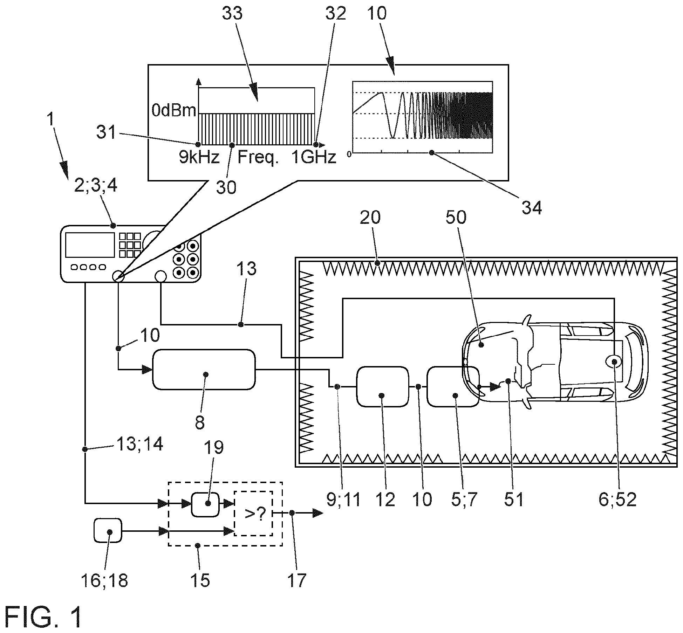

In Fig. 1 ist eine schematische Darstellung einer Ausführungsform der Anordnung 1 zum Erfassen einer durch ein Bordnetz 51 eines Kraftfahrzeugs 50 hervorgerufenen elektromagnetischen Störabstrahlung gezeigt. Die Anordnung 1 führt das offenbarte Verfahren zum Erfassen einer durch das Bordnetz 51 des Kraftfahrzeugs 50 hervorgerufenen elektromagnetischen Störabstrahlung aus.

Die Anordnung 1 umfasst einen Signalgenerator 3 und eine Empfangseinrichtung 4, die gemeinsam in Form eines EMI Receivers 2 ausgebildet sind. Ferner umfasst die Anordnung 1 ein Verbindungsmittel 5 und eine Testantenne 6, die eine Antenne 52 des Kraftfahrzeugs 50 ist.

Das Verbindungsmittel 5 umfasst einen Komponentenstecker 7, mit dem eine elektrische Verbindung zum Bordnetz 51 des Kraftfahrzeugs 50 ausgebildet werden kann.

Das Kraftfahrzeug 50 und Teile der Anordnung 1 sind in einer Testkammer 20 (engl. anechoic chamber) angeordnet, um andere elektromagnetische Störungen gering zu halten.

Der Signalgenerator 3 stellt ein elektrisches Störsignal 10 bereit, das über einen elektrooptischen Konverter 8 in ein optisches Signal 11 umgewandelt wird und mittels eines Lichtwellenleiters 9 in die Testkammer 20 geführt wird. Dort erfolgt mittels eines optischelektrischen Konverters 12 eine Wandlung zurück in ein elektrisches Störsignal 10, welches über den Komponentenstecker 7 des Verbindungsmittels 5 in das Bordnetz 51 des Kraftfahrzeugs 50 eingespeist wird. Der Komponentenstecker 7 wird beispielsweise mit einem Bordnetzstecker (nicht gezeigt) elektrisch verbunden.

Das Störsignal 10 wird beispielsweise als "common mode"-Signal in eine Versorgungsleitung des Bordnetzes 51 eingespeist, das heißt es wird eine elektrische Verbindung zur Versorgungsleitung mit Bezug zu einem Massekontakt ausgebildet. Alternativ kann das Störsignal 10 als "differential mode"-Signal beispielsweise in die High- und Low-Leitungen eines CAN-Buses eingespeist werden, das heißt es wird eine elektrische Verbindung zu den High- und Low-Leitungen des CAN-Buses ausgebildet.

Mittels der Empfangseinrichtung 4 und der Testantenne 6 wird ein frequenzaufgelöstes Messsignal 13 erfasst. Das frequenzaufgelöste Messsignal 13 wird anschließend von der Empfangseinrichtung 4 bereitgestellt und ausgegeben, beispielsweise in Form eines Frequenzspektrums 14.

Insbesondere ist vorgesehen, dass zum Bereitstellen des Störsignals 10 eine Frequenz 30 ausgehend von einer Anfangsfrequenz 31 hin zu einer Endfrequenz 32 durchgestimmt wird, wobei hiermit synchronisiert das frequenzaufgelöste Messsignal 13 erfasst wird. Das Durchstimmen erfolgt im Signalgenerator 3. Ein (über die Zeit erfasstes) Frequenzspektrum 33 des Störsignals 10 und das Störsignal 10 im Zeitbereich, das heißt über einer Zeitachse 34, sind schematisch in einem Inset der Fig. 1 gezeigt.

Die Anordnung 1 und das hiermit ausgeführte Verfahren ermöglichen es, direkt eine Störabstrahlung des Bordnetzes 51 des Kraftfahrzeugs 50 zu erfassen bzw. zu bestimmen, um ausgehen hiervor eine elektromagnetische Verträglichkeit des Bordnetzes 51 beurteilen zu können.

Es kann vorgesehen sein, dass die Anordnung 1 eine Auswerteeinrichtung 15 umfasst. Die Auswerteeinrichtung 15 vergleicht mindestens eine Messgröße 19, beispielsweise eine Spannung, einen Strom oder eine Leistung, des erfassten frequenzaufgelösten Messsignals 13 mit mindestens einem Grenzwert 16, stellt ausgehend von dem Vergleich ein Vergleichsergebnis 17 bereit und gibt das Vergleichsergebnis 17 aus, beispielsweise als Vergleichsergebnissignal, insbesondere in Form eines digitalen Datenpakets. Das Vergleichsergebnis 17 umfasst insbesondere eine Aussage darüber, ob die mindestens eine Messgröße 19 den mindestens einen Grenzwert 16 überschreitet oder nicht.

Es kann vorgesehen sein, dass die Auswerteeinrichtung 15 das Vergleichen frequenzaufgelöst durchführt, wobei ein frequenzaufgelöstes Vergleichsergebnis 17 bereitgestellt und ausgegeben wird. Das frequenzaufgelöste Messsignal 13 wird dann jeweils frequenzweise bzw. frequenzbereichsweise mit dem mindestens einen Grenzwert 16 verglichen. Nach dem Vergleichen steht für jede Frequenz 30 bzw. jeden Frequenzbereich ein Vergleichsergebnis 17 bereit, sodass dieses frequenzaufgelöst bereitgestellt werden kann. Das Vergleichsergebnis 17 umfasst dann insbesondere eine Aussage darüber, bei welchen Frequenzen bzw. welchen Frequenzbereichen die mindestens eine Messgröße 19 den mindestens einen Grenzwert 16 überschreitet und bei welchen nicht.

Es kann vorgesehen sein, dass beim Vergleichen des erfassten frequenzaufgelösten Messsignals 13 mit dem mindestens einen Grenzwert 16 frequenzabhängige Grenzwerte 18 verwendet werden. Das Vergleichen erfolgt dann für jede Frequenz bzw. jeden Frequenzbereich mit einem hierfür vorgegebenen (frequenzspezifischen) Grenzwert 18. Das Vergleichsergebnis 17 umfasst dann insbesondere eine Aussage darüber, bei welchen Frequenzen bzw. welchen Frequenzbereichen die mindestens eine Messgröße 19 den jeweils zugehörigen Grenzwert 18 überschreitet und bei welchen nicht.

Es kann vorgesehen sein, dass eine Amplitude und/oder eine Leistung des Störsignals 10 frequenzabhängig festgelegt ist oder festgelegt wird.

Hierbei kann weiterbildend insbesondere vorgesehen sein, dass die Amplituden und/oder die Leistungen für die Frequenzen 30 jeweils im Rahmen eines Konfigurierverfahrens bestimmt und festgelegt werden, wobei für eine Frequenz diejenige Amplitude und/oder diejenige Leistung des mittels des Signalgenerators 3 bereitgestellten Störsignals 10 gewählt wird, bei denen in einer definierten Testanordnung jeweils eine maximal erlaubte elektromagnetische Störabstrahlung mittels einer Testantenne erfasst wird.

Ein Testaufbau umfasst beispielsweise eine Komponente mit elektrischen Zuleitungen (z.B. Masse und Versorgungspotential) mit einer Länge von 1,5 Metern ohne einen Abschlusswiderstand, und eine Testantenne in einem Abstand von 1 Meter von der Komponente bzw. den Zuleitungen.

An einem solchen Testaufbau wird für jede der Frequenzen 30 eine vom Signalgenerator 3 bereitgestellte Amplitude bzw. bereitgestellte Leistung so gewählt, dass die Testantenne eine für diese Frequenz 30 bzw. diesen Frequenzbereich gesetzlich oder ausgehend von sonstigen Vorgaben maximal erlaubte elektromagnetische Störabstrahlung erfasst. Die maximale elektromagnetische Störabstrahlung wird hierbei insbesondere in Form eines maximal erlaubten elektrischen Feldes ausgedrückt.

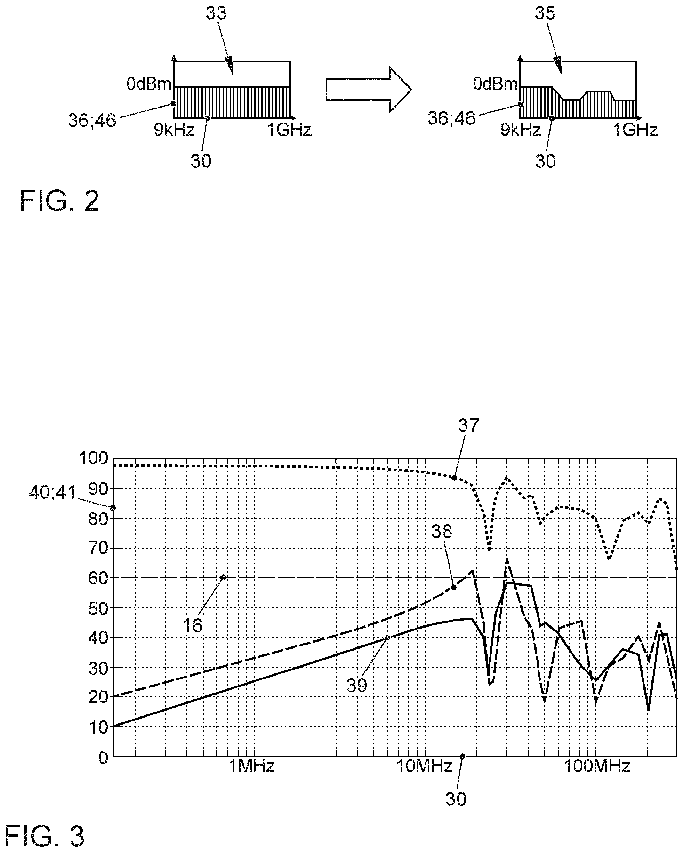

In Fig. 2 ist eine schematische Darstellung zur Verdeutlichung frequenzabhängiger Amplituden 36 und/oder Leistungen 46 im Störsignal gezeigt. Ausgehend von einem Störsignal, das bei allen Frequenzen 30 die gleiche Amplitude 36 bzw. die gleiche Leistung 46 aufweist, wird durch Anpassen der Amplituden 36 und/oder der Leistungen 46 für einzelne Frequenzen 30 und/oder Frequenzbereiche im Rahmen des beschriebenen Konfigurierverfahren aus dem gleichverteilen Frequenzspektrum 33 ein angepasstes Frequenzspektrum 35 für das Störsignal bestimmt. Das Störsignal wird dann auf Grundlage des angepassten Frequenzspektrums 35 erzeugt, bereitgestellt und in das Bordnetz eingespeist.

In Fig. 3 ist eine schematische Darstellung zur Verdeutlichung von Amplituden bzw. Leistungen eines Störsignals und von erfassten frequenzabhängigen Messsignalen 38, 39 gezeigt. Hierbei ist eine Spannung 40 in der Einheit dBµV über der Frequenz 30 als die Amplituden bzw. die Leistungen repräsentierende Größe aufgetragen. Eine Referenzkurve 37 zeigt hierbei die bei den jeweiligen Frequenzen eingespeisten Spannungen 40 (Amplituden) des Störsignals. Die zur Referenzkurve 37 gehörenden Spannungen 40 (Amplituden) wurden wie beschrieben mittels des Konfigurationsverfahrens bestimmt und gewählt.

Ferner zeigt die Fig. 3 zwei erfasste frequenzabhängige Messsignale 38, 39, die zur Verdeutlichung des Verfahrens in beispielhaften und daher stark vereinfachten Bordnetzen in einer Laborumgebung nach Einspeisen eines der Referenzkurve 37 entsprechenden Störsignals erfasst wurden. Gezeigt sind hierbei ein jeweils erfasster Strom 41 in der Einheit dBµA über der Frequenz 30.

Das stark vereinfachte Bordnetz zum frequenzabhängigen Messsignal 38 umfasst eine Zuleitung von 1,5 Metern Länge ohne einen Abschlusswiderstand. Ein Massekontakt wurde ohne zusätzliche Zuleitung hergestellt.

Das stark vereinfachte Bordnetz zum frequenzabhängigen Messsignal 39 umfasst eine Zuleitung von 3 Metern Länge ohne einen Abschlusswiderstand. Ein Massekontakt wurde über eine 54 cm lange Zuleitung hergestellt.

Beim Vergleichen der Messsignale 38, 39 lassen sich Unterschiede ausmachen: das Messsignal 38 ist bei einer Frequenz 30 von 20 MHz größer als das Messsignal 39, wohingegen das Messsignal 39 bei einer Frequenz 30 von 40 MHz größer ist als das Messsignal 38. Ein Einfluss einer konkreten Ausführung des Bordnetzes ist also deutlich zu erkennen. Mittels der beschriebenen Anordnung und des beschriebenen Verfahrens kann das Bordnetz ausgehend von einem erfassten frequenzabhängigen Messsignal 38, 39 optimiert werden. Beispielsweise können aus den Kurven der frequenzabhängigen Messsignale 38, 39 direkt Filterparameter (Frequenzbereich, Dämpfung etc.) abgeleitet werden.

Ausgehend von den frequenzabhängigen Messsignalen 38, 39 erfolgt ein Vergleich mit mindestens einem Grenzwert 16. Beispielshaft ist ein für alle Frequenzen 30 konstanter Grenzwert 16 bei 60 dBµA eingezeichnet. Der Grenzwert 16 ist lediglich beispielhaft zur Verdeutlichung des Verfahrens gewählt und entspricht nicht den gesetzlichen oder sonstigen Vorgaben. Dieser Grenzwert 16 würde im gezeigten Beispiel von dem frequenzaufgelösten Messsignal 38 bei Frequenzen 30 um 20 MHz und um 30 MHz überschritten. Dort wären Maßnahmen zum Sicherstellen einer elektromagnetischen Verträglichkeit zu treffen, beispielsweise indem entsprechende Filter in das Bordnetz eingefügt werden. Bei den zum anderen Bordnetz gehörenden frequenzaufgelösten Messsignalen 39 liegen die Messsignale 39 hingegen bei allen Frequenzen 30 unterhalb des Grenzwertes 16, sodass keine Maßnahmen hinsichtlich der elektromagnetischen Verträglichkeit zu treffen wären.

Im gezeigten Beispiel ist der Grenzwert 16 für alle Frequenzen 30 der gleiche. Es kann jedoch vorgesehen sein, dass der Grenzwert 16 frequenzabhängig ist (nicht gezeigt), um beispielsweise für verschiedene Frequenzen und/oder Frequenzbereiche vorgesehene gesetzliche und/oder sonstige Vorgaben zu berücksichtigen.

### Bezugszeichenliste

- 1: Anordnung
- 2: EMI Receiver
- 3: Signalgenerator
- 4: Empfangseinrichtung
- 5: Verbindungsmittel
- 6: Testantenne
- 7: Komponentenstecker
- 8: elektro-optischer Konverter
- 9: Lichtwellenleiter
- 10: Störsignal
- 11: optisches Signal
- 12: optisch-elektrischer Konverter
- 13: frequenzaufgelöstes Messsignal
- 14: Frequenzspektrum
- 15: Auswerteeinrichtung
- 16: Grenzwert
- 17: Vergleichsergebnis
- 18: frequenzabhängiger Messwert
- 19: Messgröße
- 20: Testkammer
- 30: Frequenz
- 31: Anfangsfrequenz
- 32: Endfrequenz
- 33: Frequenzspektrum
- 34: Zeitachse
- 35: Frequenzspektrum
- 36: Amplitude
- 37: Referenzkurve
- 38: frequenzaufgelöstes Messsignal
- 39: frequenzaufgelöstes Messsignal
- 40: Spannung
- 41: Strom
- 46: Leistung
- 50: Kraftfahrzeug
- 51: Bordnetz
- 52: Antenne

## Patentansprüche

1. Verfahren zum Erfassen einer durch ein Bordnetz (51) eines Kraftfahrzeugs (50) hervorgerufenen elektromagnetischen Störabstrahlung,
wobei das Kraftfahrzeug (50) in einer Testkammer (20) angeordnet ist,
wobei ein Störsignal (10) mittels eines außerhalb der Testkammer (20) angeordneten Signalgenerators (3) bereitgestellt wird und mittels eines innerhalb der Testkammer (20) angeordneten Verbindungsmittels (5) in das Bordnetz (51) eingespeist wird,
wobei ein frequenzaufgelöstes Messsignal (13,38,39) mittels einer Testantenne (6) und einer außerhalb der Testkammer (20) angeordneten Empfangseinrichtung (4) erfasst wird, und wobei das erfasste frequenzaufgelöste Messsignal (13,38,39) mittels der Empfangseinrichtung (4) bereitgestellt und ausgegeben wird.

2. Verfahren nach Anspruch 1, **dadurch gekennzeichnet, dass** mindestens eine Messgröße (19) des erfassten frequenzaufgelösten Messsignals (13,38,39) mittels einer Auswerteeinrichtung (15) mit mindestens einem Grenzwert (16) verglichen wird, und wobei ein Vergleichsergebnis (17) bereitgestellt und ausgeben wird.

3. Verfahren nach Anspruch 1 oder 2, **dadurch gekennzeichnet, dass** zum Bereitstellen des Störsignals (10) eine Frequenz (30) ausgehend von einer Anfangsfrequenz (31) hin zu einer Endfrequenz (32) durchgestimmt wird, wobei hiermit synchronisiert das frequenzaufgelöste Messsignal (13,38,39) erfasst wird.

4. Verfahren nach Anspruch 2 oder 3, **dadurch gekennzeichnet, dass** das Vergleichen frequenzaufgelöst erfolgt, wobei ein frequenzaufgelöstes Vergleichsergebnis (17) bereitgestellt und ausgegeben wird.

5. Verfahren nach einem der Ansprüche 2 bis 4, **dadurch gekennzeichnet, dass** beim Vergleichen des erfassten frequenzaufgelösten Messsignals (13,38,39) mit dem mindestens einen Grenzwert (16) frequenzabhängige Grenzwerte (18) verwendet werden.

6. Verfahren nach einem der vorangegangenen Ansprüche, **dadurch gekennzeichnet, dass** eine Amplitude und/oder eine Leistung des Störsignals (10) frequenzabhängig festgelegt ist oder festgelegt wird.

7. Verfahren nach Anspruch 6, **dadurch gekennzeichnet, dass** die Amplituden und/oder die Leistungen für die Frequenzen (30) jeweils im Rahmen eines Konfigurierverfahrens bestimmt und festgelegt werden, wobei für eine Frequenz (30) diejenige Amplitude und/oder diejenige Leistung des mittels des Signalgenerators (3) bereitgestellten Störsignals (10) gewählt wird, bei denen in einer definierten Testanordnung jeweils eine maximal erlaubte elektromagnetische Störabstrahlung mittels einer Testantenne erfasst wird.

8. Verfahren nach einem der vorangegangenen Ansprüche, **dadurch gekennzeichnet, dass** das Verbindungsmittel (5) mindestens einen Komponentenstecker (7) umfasst, wobei eine elektrische Verbindung zum Bordnetz (51) zum Einspeisen des Störsignals (10) mittels des mindestens einen Komponentensteckers (7) ausgebildet wird.

9. Anordnung (1) zum Erfassen einer durch ein Bordnetz (51) eines Kraftfahrzeugs (50) hervorgerufenen elektromagnetischen Störabstrahlung, umfassend:
eine Testkammer (20),
einen außerhalb der Testkammer (20) angeordneten Signalgenerator (3) zum Bereitstellen eines Störsignals (10),
ein innerhalb der Testkammer (20) angeordnetes Verbindungsmittel (5) zum Einspeisen des Störsignals (10) in das Bordnetz (50),
eine Testantenne (6) und eine außerhalb der Testkammer (20) angeordnete Empfangseinrichtung (4) zum Erfassen eines frequenzaufgelösten Messsignals (13,38,39),
wobei die Empfangseinrichtung (4) derart ausgebildet ist, das erfasste frequenzaufgelöste Messsignal (13,38,39) bereitzustellen und auszugeben.

10. Anordnung (1) nach Anspruch 9, **gekennzeichnet durch** eine Auswerteeinrichtung (15), wobei die Auswerteeinrichtung (15) derart ausgebildet ist, mindestens eine Messgröße (19) des erfassten frequenzaufgelösten Messsignals (13,38,39) mit mindestens einem Grenzwert (16) zu vergleichen, und ein Vergleichsergebnis (17) bereitzustellen und auszugeben.

## Claims

1. Method for detecting electromagnetic interference radiation caused by an on-board electrical system (51) of a motor vehicle (50),
the motor vehicle (50) being arranged in a test chamber (20),
an interfering signal (10) being provided by means of a signal generator (3) arranged outside the test chamber (20) and being fed into the on-board electrical system (51) by means of a connecting means (5) arranged inside the test chamber (20),
a frequency-resolved measurement signal (13,38,39) being detected by means of a test antenna (6) and a receiving device (4) arranged outside the test chamber (20), and the detected frequency-resolved measurement signal (13,38,39) being provided and output by means of the receiving device (4).

2. Method according to claim 1, **characterized in that** at least one measured variable (19) of the detected frequency-resolved measurement signal (13,38,39) is compared with at least one limit value (16) by means of an evaluation device (15), and a comparison result (17) being provided and output.

3. Method according to claim 1 or claim 2, **characterized in that,** to provide the interfering signal (10), a frequency (30) is tuned starting from an initial frequency (31) to a final frequency (32), the frequency-resolved measurement signal (13,38,39) being detected in synchronization therewith.

4. Method according to claim 2 or claim 3, **characterized in that** the comparison is carried out in a frequency-resolved manner, a frequency-resolved comparison result (17) being provided and output.

5. Method according to any of claims 2 to 4, **characterized in that,** when comparing the detected frequency-resolved measurement signal (13,38,39) with the at least one limit value (16), frequency-dependent limit values (18) are used.

6. Method according to any of the preceding claims, **characterized in that** an amplitude and/or a power of the interfering signal (10) is set in a frequency-dependent manner.

7. Method according to claim 6, **characterized in that** the amplitudes and/or the powers for the frequencies (30) are each determined and set within the framework of a configuration process, the amplitude and/or the power of the interfering signal (10) provided by means of the signal generator (3) at which a maximum permissible electromagnetic interference radiation is detected by means of a test antenna in a defined test arrangement being selected for a frequency (30).

8. Method according to any of the preceding claims, **characterized in that** the connecting means (5) comprises at least one component plug (7), an electrical connection to the on-board electrical system (51) for feeding in the interfering signal (10) being formed by means of the at least one component plug (7).

9. Arrangement (1) for detecting electromagnetic interference radiation caused by an on-board electrical system (51) of a motor vehicle (50), comprising:
a test chamber (20),
a signal generator (3) arranged outside the test chamber (20) for providing an interfering signal (10),
a connecting means (5) arranged inside the test chamber (20) for feeding the interfering signal (10) into the on-board electrical system (50),
a test antenna (6) and a receiving device (4) arranged outside the test chamber (20) for detecting a frequency-resolved measurement signal (13,38,39),
the receiving device (4) being designed to provide and output the detected frequency-resolved measurement signal (13,38,39).

10. Arrangement (1) according to claim 9, **characterized by** an evaluation device (15), the evaluation device (15) being designed to compare at least one measured variable (19) of the detected frequency-resolved measurement signal (13,38,39) with at least one limit value (16), and to provide and output a comparison result (17).

## Revendications

1. Procédé de détection d'un rayonnement électromagnétique parasite provoqué par un réseau de bord (51) d'un véhicule automobile (50),
dans lequel le véhicule automobile (50) est agencé dans une chambre de test (20),
dans lequel un signal parasite (10) est mis à disposition par le biais d'un générateur de signaux (3) agencé à l'extérieur de la chambre de test (20) et est injecté dans le réseau de bord (51) par le biais d'un moyen de liaison (5) agencé à l'intérieur de la chambre de test (20),
dans lequel un signal de mesure (13, 38, 39) résolu en fréquence est détecté par le biais d'une antenne de test (6) et d'un dispositif de réception (4) agencé à l'extérieur de la chambre de test (20), et dans lequel le signal de mesure (13, 38, 39) résolu en fréquence détecté est mis à disposition et émis par le biais du dispositif de réception (4).

2. Procédé selon la revendication 1, **caractérisé en ce qu'**au moins une grandeur de mesure (19) du signal de mesure (13, 38, 39) résolu en fréquence détecté est comparée à au moins une valeur limite (16) par le biais d'un dispositif d'évaluation (15), et dans lequel un résultat de comparaison (17) est mis à disposition et émis.

3. Procédé selon la revendication 1 ou 2, **caractérisé en ce que** pour mettre à disposition le signal parasite (10), une fréquence (30) est accordée en partant d'une fréquence initiale (31) jusqu'à une fréquence finale (32), dans lequel le signal de mesure (13, 38, 39) résolu en fréquence est détecté de manière synchronisée avec celle-ci.

4. Procédé selon la revendication 2 ou 3, **caractérisé en ce que** la comparaison est effectuée de manière résolue en fréquence, dans lequel un résultat de comparaison (17) résolu en fréquence est mis à disposition et émis.

5. Procédé selon l'une des revendications 2 à 4, **caractérisé en ce que** des valeurs limites (18) dépendant de la fréquence sont utilisées lors de la comparaison du signal de mesure (13, 38, 39) résolu en fréquence détecté avec l'au moins une valeur limite (16).

6. Procédé selon l'une des revendications précédentes,
**caractérisé en ce qu'**une amplitude et/ou une puissance du signal parasite (10) est fixée ou sera fixée en fonction de la fréquence.

7. Procédé selon la revendication 6, **caractérisé en ce que** les amplitudes et/ou les puissances pour les fréquences (30) sont respectivement déterminées et fixées dans le cadre d'un procédé de configuration, dans lequel, pour une fréquence (30), sont choisies l'amplitude et/ou la puissance du signal parasite (10) mis à disposition par le biais du générateur de signaux (3), pour laquelle un rayonnement parasite électromagnétique maximal autorisé est respectivement détecté par le biais d'une antenne de test dans un agencement de test défini.

8. Procédé selon l'une des revendications précédentes,
**caractérisé en ce que** le moyen de liaison (5) comprend au moins un connecteur de composant (7), dans lequel une liaison électrique au réseau de bord (51) est formée pour injecter le signal parasite (10) par le biais de l'au moins un connecteur de composant (7).

9. Agencement (1) de détection d'un rayonnement électromagnétique parasite provoqué par un réseau de bord (51) d'un véhicule automobile (50), comprenant :
une chambre de test (20),
un générateur de signaux (3) agencé à l'extérieur de la chambre de test (20) pour mettre à disposition un signal parasite (10),
un moyen de liaison (5) agencé à l'intérieur de la chambre de test (20) pour injecter le signal parasite (10) dans le réseau de bord (50),
une antenne de test (6) et un dispositif de réception (4) agencé à l'extérieur de la chambre de test (20) pour détecter un signal de mesure (13, 38, 39) résolu en fréquence,
dans lequel le dispositif de réception (4) est conçu de manière à mettre à disposition et émettre le signal de mesure (13, 38, 39) résolu en fréquence détecté.

10. Agencement (1) selon la revendication 9, **caractérisé par** un dispositif d'évaluation (15), dans lequel le dispositif d'évaluation (15) est conçu de manière à comparer au moins une grandeur de mesure (19) du signal de mesure (13, 38, 39) résolu en fréquence détecté à au moins une valeur limite (16), et à mettre à disposition et émettre un résultat de comparaison (17).
